# EUROPEAN PATENT APPLICATION

(11) **EP 4 648 103 A1**
(43) Date of publication of application: **12.11.2025**
(21) Application number: 25174036.1
(22) Date of filing: 02.05.2025
(51) Int. Cl.: H01L 23/495, H01L 23/31, H01L 23/48, H01L 23/367, H01L 23/373, H01L 21/48

(54) **LEAD-FRAME PACKAGE WITH IMPROVED HEAT DISSIPATION**

(30) Priority: 10.05.2024 US 202463645477 P; 09.04.2025 US 202519174215
(71) Applicant: STMicroelectronics International N.V., 1228 Plan-les-Ouates, Geneva (CH)
(72) Inventor: TALLEDO, Jefferson Sismundo, 4027 CALAMBA (PH)
(74) Representative: Casalonga

(57) **Abstract**

An example lead-frame package, a method of manufacturing a lead-frame package, and an electrical system comprising a lead-frame package with improved heat dissipation are provided. An example lead-frame package with improved heat dissipation includes a first surface and a second surface opposite the first surface. The example lead-frame package further includes a semiconductor integrated circuit (IC) thermally coupled to a die pad, the die pad forming a portion of the first surface of the lead-frame package. The example lead-frame package further includes a thermal dissipation surface at the second surface of the lead-frame package thermally coupled to the semiconductor IC. The thermal dissipation surface provides a thermal dissipation path from the semiconductor IC to the second surface of the lead-frame package.

## Description

### CROSS-REFERENCE TO RELATED APPLICATIONS

This application claims the benefit of U.S. Provisional Patent Application No. 63/645,477, filed May 10, 2024, the entire contents of which are hereby incorporated by reference in their entirety.

### TECHNOLOGICAL FIELD

Embodiments of the present disclosure relate generally to lead-frame packages and more particularly, to heat dissipation from a lead-frame package.

### BACKGROUND

Many electronic systems utilize printed circuit boards (PCBs) to support and connect the various electrical components of an electrical system. For example, a PCB may include a rigid structure with a plurality of mount regions configured to receive various electrical components. The PCB may further include conductive traces or paths to enable electrical connections between the various electrical components. A PCB may commonly receive surface-mounted and/or socketed electrical components, including various integrated circuits (ICs). One example structure for connecting an IC to a PCB is a lead-frame package.

Applicant has identified many technical challenges and difficulties associated with heat dissipation in a lead-frame package. Through applied effort, ingenuity, and innovation, Applicant has solved problems related to heat dissipation in a lead-frame package by developing solutions embodied in the present disclosure, which are described in detail below.

### BRIEF SUMMARY

Various embodiments are directed to an example lead-frame package, a method of manufacturing a lead-frame package, and an electrical system comprising a lead-frame package with improved heat dissipation. A lead-frame package comprising a first surface and a second surface opposite the first surface; a semiconductor integrated circuit (IC) thermally coupled to a die pad, the die pad comprising a portion of the first surface of the lead-frame package; and a thermal dissipation surface at the second surface of the lead-frame package thermally coupled to the semiconductor IC. In some embodiments, the thermal dissipation surface provides a thermal dissipation path from the semiconductor IC to the second surface of the lead-frame package.

In some embodiments, the lead-frame package further comprises a molding material formed around the semiconductor IC protecting the semiconductor IC from a surrounding environment and defining at least a portion of the first surface and the second surface, wherein the thermal dissipation surface is exposed to the surrounding environment.

In some embodiments, the lead-frame package further comprises a lead terminating at the first surface and electrically coupled to the semiconductor IC, wherein the molding material insulates the lead from the die pad.

In some embodiments, the lead is electrically coupled to the semiconductor IC by a conductive bond wire.

In some embodiments, the lead is configured to attach to a conductive pad of a printed circuit board (PCB).

In some embodiments, the first surface comprises a plurality of rows of leads.

In some embodiments, the molding material comprises at least one of a resin and a polymer plastic.

In some embodiments, the lead-frame package further comprises a thermally conductive die pad path creating a thermally conductive path directly from the die pad to the thermal dissipation surface.

In some embodiments, the lead-frame package further comprises a plurality of finned protrusions extending from the thermal dissipation surface.

In some embodiments, the thermal dissipation surface comprises copper.

In some embodiments, the lead-frame package comprises a quad-flat no-leads (QFN) package.

An example method of manufacturing a lead-frame package is further provided. In some embodiments, the example method comprises disposing a semiconductor IC on a thermally conductive die base, wherein the die base comprises a first surface of the lead-frame package. In some embodiments, the example method further comprises disposing a molding material around the semiconductor IC, forming a barrier between the semiconductor IC and a surrounding environment, defining a second surface of the lead-frame package opposite the first surface. In some embodiments, the example method further comprises forming a thermally conductive semiconductor IC path from the semiconductor IC to the second surface of the lead-frame package, and disposing a thermal dissipation surface on the second surface of the lead-frame package, wherein the thermal dissipation surface provides a thermal dissipation path from the semiconductor IC to the second surface of the lead-frame package.

In some embodiments, the example method further comprises etching the die base to form a die pad and a lead, exposing a portion of the molding material, wherein the molding material insulates the die pad from the lead.

In some embodiments, the example method further comprises forming an electrically conductive path from the lead to the semiconductor IC.

In some embodiments, the example method further comprises forming a thermally conductive path from the die pad to the semiconductor IC.

In some embodiments, the lead is configured to attach to a conductive pad of a printed circuit board (PCB).

In some embodiments, the example method further comprises forming a plurality of rows of leads from the die base.

In some embodiments, the method further comprises forming a plurality of finned protrusions extending from the thermal dissipation surface away from the second surface.

In some embodiments, the molding material comprises at least one of a resin and a polymer plastic.

An example electrical system is further provided. In some embodiments, the example electrical system comprises a printed circuit board (PCB) comprising a conductive pad and a thermal dissipation region; a lead-frame package comprising: a first surface and a second surface opposite the first surface; a semiconductor IC thermally coupled to a die pad, the die pad comprising a first portion of the first surface of the lead-frame package; a lead electrically coupled to the semiconductor IC, the lead comprising a second portion of the first surface thermally isolated from the first portion; a thermal dissipation surface at the second surface of the lead-frame package thermally coupled to the semiconductor IC, wherein the thermal dissipation surface provides a first thermal dissipation path from the semiconductor IC to the second surface of the lead-frame package; wherein the lead is electrically coupled to the conductive pad of the PCB, and wherein the die pad provides a second thermal dissipation path from the semiconductor IC to the thermal dissipation region of the PCB.

### BRIEF DESCRIPTION OF THE DRAWINGS

Reference will now be made to the accompanying drawings. The components illustrated in the figures may or may not be present in certain embodiments described herein. Some embodiments may include fewer (or more) components than those shown in the figures in accordance with an example embodiment of the present disclosure.
FIG. 1 illustrates a perspective view of an example lead-frame package in accordance with an example embodiment of the present disclosure.
FIG. 2 illustrates a cross-section view of an example lead-frame package and PCB in accordance with an example embodiment of the present disclosure.
FIG. 3 illustrates a cross-section view of an example lead-frame package comprising a thermal dissipation surface in accordance with an example embodiment of the present disclosure.
FIG. 4 illustrates heat dissipation paths of an example lead-frame package in accordance with an example embodiment of the present disclosure.
FIG. 5A - FIG. 5B illustrate a process for manufacturing a lead-frame package comprising a thermal dissipation surface in accordance with an example embodiment of the present disclosure.
FIG. 6 illustrates a perspective view of an example lead-frame package comprising a thermal dissipation surface in accordance with an example embodiment of the present disclosure.
FIG. 7 illustrates a cross-section view of an example lead-frame package comprising a thermal dissipation surface having finned protrusions in accordance with an example embodiment of the present disclosure.
FIG. 8 illustrates a perspective view of an example lead-frame package comprising a thermal dissipation surface having finned protrusions in accordance with an example embodiment of the present disclosure.
FIG. 9 includes a flowchart depicting an example method of manufacturing a lead-frame package in accordance with an example embodiment of the present disclosure.

### DETAILED DESCRIPTION

Example embodiments will be described more fully hereinafter with reference to the accompanying drawings, in which some, but not all embodiments of the inventions of the disclosure are shown. Indeed, embodiments of the disclosure may be embodied in many different forms and should not be construed as limited to the embodiments set forth herein; rather, these embodiments are provided so that this disclosure will satisfy applicable legal requirements. Like numbers refer to like elements throughout.

Various example embodiments address technical problems associated with dissipating heat generated by a semiconductor IC utilizing a lead-frame package to provide electrical connections in an electrical system. As understood by those of skill in the field to which the present disclosure pertains, there are numerous example scenarios in which a user may desire improved heat dissipation from a semiconductor IC in a lead-frame package.

Many electronic systems utilize printed circuit boards (PCBs) to support and connect the various electrical components of the electrical system. For example, a PCB may include a rigid structure with a plurality of mount regions configured to receive various electrical components. The PCB may further include conductive traces or paths to enable electrical connections between the various electrical components. A PCB may commonly receive surface-mounted and/or socketed electrical components, including various semiconductor ICs.

One example structure for connecting an IC to a PCB is a lead-frame package. A lead-frame package is a surface-mount technology providing structural support for a semiconductor IC. In addition, a lead-frame package may provide protection from certain environmental factors in a surrounding environment. The lead-frame package includes conductive surfaces (e.g., leads) to provide an electrical connection between the PCB and the semiconductor IC without through holes. The leads are positioned on the bottom of the lead-frame package and are positioned to be electrically coupled with conductive pads on the surface of the PCB. The lead-frame package protects the electrical components and electrical connections of the semiconductor IC from environmental factors from the surrounding environment, ensuring reliability of the electrical system even in extreme conditions. Example lead-frame packages include quad-flat no-leads (QFN) packages and quad-flat no-leads multi-row (QFNmr) packages.

The semiconductor ICs in the lead-frame package and coupled with the PCB generate heat during operation. Too much heat at a semiconductor IC during operation can damage the semiconductor IC and/or other electrical components. Some example lead-frame packages include a die pad to which the semiconductor IC is thermally coupled. The die pad is configured to receive and dissipate heat from the semiconductor IC. In some embodiments, the PCB may additionally provide thermal dissipation structures at the intersection of the thermal die pad and the PCB. For example, a thermally conductive portion of the PCB may be positioned to interface with the die pad of the lead-frame package. The thermal die pad and associated thermal dissipation structures create a thermal dissipation path away from the semiconductor IC and toward the PCB. Thus, the traditional technique for heat dissipation in a lead-frame package includes only one primary path for heat dissipation, towards the PCB. One primary path for heat dissipation greatly limits the amount of heat dissipated and the rate at which that heat is dissipated. In addition, in some embodiments, a die attach substance may be utilized to attach the semiconductor IC to the thermal die pad. The die attach substance may experience delamination or otherwise include voids. Voids in the die attach substance may reduce heat dissipation through thermal die pad and the PCB.

The various example embodiments described herein provide a lead-frame package configured to provide improved heat dissipation to a semiconductor IC of the lead-frame package. Improved heat dissipation is obtained by adding one or more additional thermal dissipation paths through the top surface of the lead-frame package, opposite the conductive leads. For example, in some embodiments, a thermal dissipation surface may be formed on the top surface of the lead-frame package. The thermal dissipation surface may be thermally coupled to the semiconductor IC by one or more thermally conductive paths. The thermally conductive paths and thermal dissipation surface provide a thermal dissipation path from the semiconductor IC to the top surface of the lead-frame package. The thermal dissipation path from the semiconductor IC to the top surface, along with a thermal dissipation path from the semiconductor IC toward a PCB through a thermally conductive die pad may provide significant improvements in heat dissipation from the semiconductor IC within the lead-frame package.

In addition, in some embodiments, a thermally conductive path from the thermal dissipation surface on the top surface of the lead-frame package to the die pad may be formed, further improving the heat dissipation from the semiconductor IC within the lead-frame package. Further, in some embodiments, thermally conductive finned protrusions may be integrated with the thermal dissipation surface on the top surface of the lead-frame package. The finned protrusions may enable more efficient heat transfer from the thermal dissipation surface to the surrounding external environment.

As a result of the herein described example embodiments, and in some examples, the dissipation of heat from a semiconductor IC within a lead-frame package may be greatly improved. Improvements in the dissipation of heat from the semiconductor IC may result in improvements in performance and reliability of semiconductor ICs, especially in harsh environments.

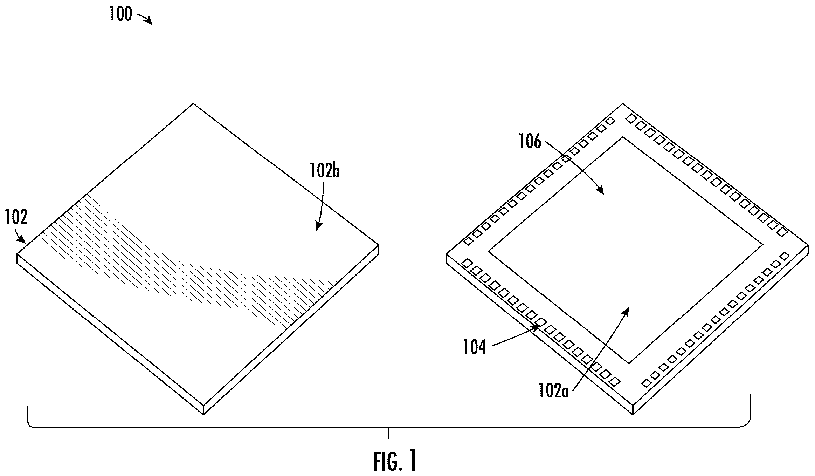

Referring now to FIG. 1, an example lead-frame package 100 is provided. As depicted in FIG. 1, the example lead-frame package 100 includes a molding material 102 forming a barrier between a semiconductor IC and the surrounding environment. The molding material 102 defines a top surface 100b and a bottom surface 100a of the lead-frame package 100. As further depicted in FIG. 1, a die pad 106 and a plurality of leads 104 comprise at least a portion of the bottom surface 100a of the lead-frame package 100.

A lead-frame package 100 is any structure for providing an electrical connection to a semiconductor IC without the use of through-holes or exposed wire bonds. A lead-frame package 100 provides a surface-mount and/or socket mount from a semiconductor IC contained within the lead-frame package 100 to an electrical system (e.g., a PCB). Conductive bond wires are contained within the lead-frame package 100 with an electrical connection to the semiconductor IC provided through a plurality of leads 104 exposed on the bottom surface 100a of the lead-frame package 100. A lead-frame package 100 provides structural support to a semiconductor IC and the conductive bond wires. The lead-frame package 100 further protects the electrical components, including the semiconductor IC, and from the environmental factors of a surrounding environment, such as wind, rain, dirt, liquids, extreme temperatures, and so on. Non-limiting examples of lead-frame packages 100 may include quad-flat no-leads (QFN) packages, quad-flat no-leads multi-row (QFNmr) packages, dual-flat no-leads (DFN) packages, and so on. Although primarily depicted as a lead-frame package 100 comprising a molding material 102, in some embodiments, the lead-frame package 100 may comprise an air cavity lead-frame package.

As depicted in FIG. 1, the example lead-frame package 100 includes a molding material 102. The molding material 102 comprises any non-conductive material configured to protect a semiconductor IC within the lead-frame package 100 from a surrounding environment. For example, in some embodiments, a semiconductor IC may be on an electrical system in a harsh environment (e.g., high temperatures, low temperatures, exposed to dirt, water, dust, sand, etc.). For example, a lead-frame package 100 may be utilized to protect a semiconductor IC in a portion of an automobile (e.g., engine, chassis, driveline, etc.). As depicted in FIG. 1, the molding material 102 is formed to define a bottom surface 100a and a top surface 100b of the lead-frame package 100. The molding material 102 may comprise a resin, polymer plastic, or other insulating material.

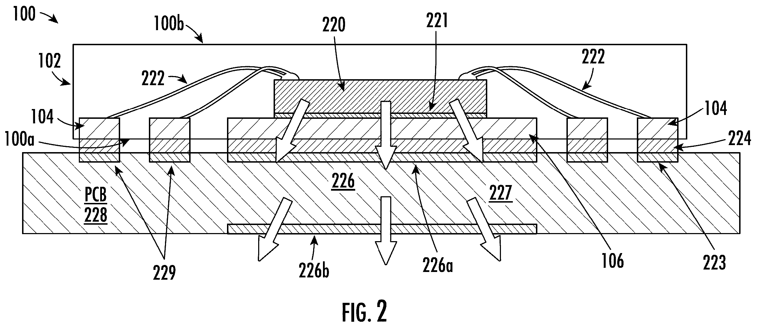

As further depicted in FIG. 1, the example lead-frame package 100 includes a die pad 106 comprising at least a portion of the bottom surface 100a of the lead-frame package 100. The die pad 106 comprises any thermally conductive material configured to transfer heat from the lead-frame package 100 to a fluid (e.g., air, liquid coolant) in the surrounding environment and/or to a thermal dissipation region of a mounting surface (e.g., PCB 228 as described in relation to FIG. 2). A die pad 106 may comprise copper, aluminum, aluminum alloys, or other similar thermally conductive material. The material comprising a die pad 106 may depend on the application, heat intensity, production method, budget, and other factors.

As further depicted in FIG. 1, the example lead-frame package 100 includes a plurality of leads 104. Leads 104 are any conductive surfaces configured to provide an electrical connection to a semiconductor IC within a lead-frame package 100. The leads 104 may be electrically coupled to distinct electrical components of the semiconductor IC within the lead-frame package 100. For example, one lead 104 may be electrically coupled to a clock, another may be electrically coupled to a reset signal, a third may be electrically coupled to an output signal of the semiconductor IC, and so on. The leads 104 may be positioned to align with one or more conductive pads on the mounting surface of an electrical system (e.g., a PCB). The leads 104 may enable a lead-frame package 100 to be electrically coupled to an electrical system utilizing surface-mount technologies, socket-mount technologies, or other similar mount technologies. In some embodiments, the lead-frame package 100 may include multiple rows of leads 104 increasing the number of electrical connections between a semiconductor IC and the electrical system.

Referring now to FIG. 2, a cross-section of an example lead-frame package 100 electrically coupled to a PCB 228 is provided. As depicted in FIG. 2, the example lead-frame package 100 includes a semiconductor IC 220 attached to a thermal die pad 106 with a die attach substance 221. As further depicted in FIG. 2, the lead-frame package 100 includes a plurality of conductive bond wires 222, each electrically coupled to a lead 104 in a row 229 of leads 104. The thermal die pad 106 and plurality of leads 104 comprise a portion of the bottom surface 100a of the lead-frame package 100. As further depicted in FIG. 2, a molding material 102 is formed to protect the semiconductor IC 220 and conductive bond wires 222, defining a top surface 100b of the lead-frame package 100. The depicted PCB 228 of FIG. 2 includes a plurality of conductive pads 223 aligned in rows 229. The depicted PCB 228 further includes a thermal dissipation region 226 including thermal conductive surfaces 226a, 226b. The PCB 228 is electrically coupled to the leads 104 with a conductive bond 224.

As depicted in FIG. 2, the example lead-frame package 100 includes a semiconductor IC 220. A semiconductor IC 220 (e.g., semiconductor die) is any block of semiconductor material utilizing circuitry and/or electrical components to perform one or more functions. A semiconductor IC may include a processor, reconfigurable fabric, passive electrical components, active electrical components, memory, communications circuitry, and/or any other electrical components necessary to perform the functionality of the semiconductor IC 220.

A semiconductor IC 220 is further configured to receive and/or generate one or more electrical signals. The one or more electrical signals are transmitted between the semiconductor IC and an electrical system through the one or more leads 104. As depicted in FIG. 1, the one or more leads 104 provide an external conductive surface to electrically interface with the semiconductor IC 220.

As depicted in FIG. 2, each lead 104 is electrically coupled to the semiconductor IC 220 with a conductive bond wire 222. A conductive bond wire 222 is any electrically conductive material forming a conductive path from a lead 104 to an electrical input and/or output of the semiconductor IC 220. The conductive bond wire 222 facilitates the transmission of electrical signals between the semiconductor IC 220 and the leads 104, providing an electrical connection to an external electrical system. Conductive bond wires 222 may comprise aluminum, copper, silver, gold, or other similar conductive materials. In some embodiments, a conductive bond wire 222 may be attached using a ball bonding technique, or a wedge bonding technique.

As further depicted in FIG. 2, a semiconductor IC 220 may be attached to the thermal die pad 106 using a die attach substance 221. A die attach substance 221 is any bonding substance configured to enable a thermally conductive interface between the semiconductor IC 220 and the die pad 106. The die attach substance 221 enables the transfer of heat from the semiconductor IC 220 and to the thermal die pad 106. In some embodiments, the die attach substance 221 may delaminate or otherwise form pockets or voids between the semiconductor IC 220 and the thermal die pad 106. Voids within the thermal dissipation path 227 reduce the transfer of heat between the semiconductor IC 220 and the die pad 106.

As further depicted in FIG. 2, the example lead-frame package 100 is coupled to a PCB 228 using a conductive bond 224. A PCB 228 is a structure comprising laminated layers of conductive and insulating material, providing rigid structure and electrical connections between various electrical components (e.g., lead-frame packages 100) of a circuit. A PCB 228 may utilize copper or a similar conductor to form electrical paths between the electrical components comprising a circuit. The conductive layers may be accompanied by one or more insulating layers. Insulating layers may be comprised of an insulating material, such as fiberglass. An PCB 228 may enable the integration of one or more electrical components by surface mount technologies. Surface mount technologies provide for attaching electrical components directly to the surface of a PCB 228. Surface mount technologies enable increased automation in the manufacture of circuits utilizing a PCB 228. In addition, surface mount technologies reduce cost and improve the quality and reliability of the circuit.

A PCB 228 may include a plurality of conductive pads 223 configured to interface with the leads 104 of a lead-frame package 100. A conductive pad 223 is any conductive portion on a surface of a PCB 228 configured to provide an electrical connection to one or more electrical paths on the PCB 228. A conductive pad 223 may comprise copper or another similar conductive material. The conductive pads 223 may be configured to align with the leads 104 of a lead-frame package 100. A conductive bond 224 such as solder, may be utilized to attach the leads 104 of the lead-frame package 100 to the conductive pads 223 of the PCB 228.

As depicted in FIG. 2, in some embodiments, a plurality of leads 104 may be organized in rows 229. Rows 229 of leads 104 may enable more leads 104 providing electrical connections to the semiconductor IC 220 on the bottom surface 100a of the lead-frame package 100. In such an embodiment, the PCB 228 may similarly include multiple rows 229 of conductive pads 223 configured to align with the leads 104.

As further depicted in FIG. 2, a PCB 228 may include a thermal dissipation region 226 comprising one or more thermal dissipation structures (e.g., thermal conductive surfaces 226a, 226b). A thermal dissipation region 226 of a PCB 228 may be any region of the PCB 228 aligned to interface with the die pad 106 of one or more lead-frame packages 100 in order to provide a thermal dissipation path 227 from the semiconductor IC 220 to and/or through the PCB 228. In some embodiments, the thermal dissipation region 226 may include one or more thermal conductive surfaces 226a, 226b. A thermal conductive surface 226a may be thermally coupled with the die pad 106 to enable the transfer of heat along the thermal dissipation path 227 from the semiconductor IC 220 to the die pad 106, and to the thermal dissipation region 226. In some embodiments, the thermal conductive surfaces 226a, 226b may be thermally coupled, enabling the dissipation of heat at the surface of the PCB 228 opposite the lead-frame package 100. In some embodiments, a heat sink structure may be positioned on the thermal conductive surface 226b opposite the lead-frame package 100 enabling heat dissipation in the heat sink structure. In some embodiments, the thermal dissipation region 226 of the PCB 228 may be open, exposing the die pad 106 directly to the environment opposite the PCB 228.

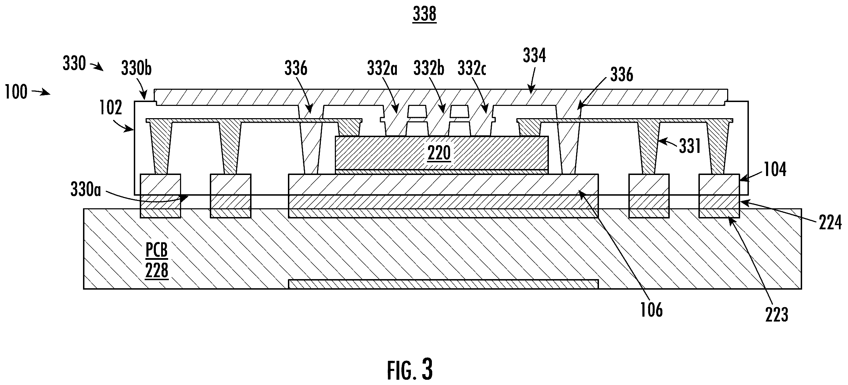

Referring now to FIG. 3, an example lead-frame package 330 attached to a PCB 228 is provided. As depicted in FIG. 3, the example lead-frame package 330 includes a thermal dissipation surface 334 comprising a portion of the top surface 330b of the lead-frame package 330. The thermal dissipation surface 334 is thermally coupled to the semiconductor IC 220 by a thermally conductive path 332a - 332c. In addition, the thermal dissipation surface 334 is thermally coupled to the die pad 106 by a thermally conductive die pad path 336. As further depicted in FIG. 3, the lead-frame package 330 includes a plurality of conductive vias 331 electrically coupling the semiconductor IC 220 to each lead 104 of the lead-frame package 330. The leads 104 are further electrically coupled to conductive pads 223 of the PCB 228 with a conductive bond 224.

As depicted in FIG. 3, the example lead-frame package 330 includes a thermal dissipation surface 334. A thermal dissipation surface 334 is a thermal conductive material disposed on the top surface 330b of a lead-frame package 330, opposite the leads 104 and die pad 106, and thermally coupled to the semiconductor IC 220 such that a thermal dissipation path is formed from the semiconductor IC 220 to the top surface 330b of the lead-frame package 330. A thermal dissipation surface 334 enables heat from the semiconductor IC 220 to transmit to the thermal dissipation surface 334 and dissipate when exposed to the external environment 338. The external environment 338 may include air, liquid coolant, or another fluid.

A thermal dissipation surface 334 comprises a thermal conductive material. A thermal conductive material is any material exhibiting an ability to conduct heat. A material with a high thermal conductivity may enable a transfer of heat into the external environment 338 with greater efficiency. In some embodiments, a material with a thermal conductivity greater than 100 Watts per meter per degree Kelvin may comprise the thermal dissipation surface 334, for example, Zinc, Aluminum, Copper, Silver, and so on.

As further depicted in FIG. 3, the thermal dissipation surface 334 is thermally coupled to the semiconductor IC 220 by one or more thermally conductive paths 332a - 332c. A thermally conductive path 332a - 332c is any channel, conduit, via, or other path of thermally conductive material enabling the transmission of heat from the semiconductor IC 220 to the thermal dissipation surface 334 and external environment 338s. A lead-frame package 330 may include a plurality of thermally conductive paths 332a - 332c. The efficiency with which heat is dissipated from the semiconductor IC 220 may depend on the number, size, material, and other factors related to the thermally conductive paths 332a - 332c. A thermally conductive path 332a - 332c may comprise the same material as the thermal dissipation surface 334. For example, the thermally conductive path 332a - 332c may comprise Zinc, Aluminum, Copper, Silver, and so on. In some embodiments, a material with a thermal conductivity greater than 100 Watts per meter per degree Kelvin may comprise the thermally conductive path 332a - 332c.

As further depicted in FIG. 3, the example lead-frame package 330 includes a plurality of thermally conductive die pad path 336. A thermally conductive die pad path 336 is any channel, conduit, via, or other path of thermally conductive material enabling the transmission of heat from the die pad 106 to the thermal dissipation surface 334 and external environment 338s. A lead-frame package 330 may include a plurality of thermally conductive die pad path 336. The plurality of thermally conductive die pad paths 336 provide another thermal dissipation path from the semiconductor IC 220 to the thermal dissipation surface 334 by way of the die pad 106. The efficiency with which heat is dissipated from the semiconductor IC 220 and die pad 106 may depend on the number, size, material, and other factors related to the thermally conductive die pad path 336. A thermally conductive die pad path 336 may comprise the same material as the thermal dissipation surface 334 and/or the thermally conductive path 332a - 332c. For example, the thermally conductive die pad path 336 may comprise Zinc, Aluminum, Copper, Silver, and so on. In some embodiments, a material with a thermal conductivity greater than 100 Watts per meter per degree Kelvin may comprise the thermally conductive die pad path 336.

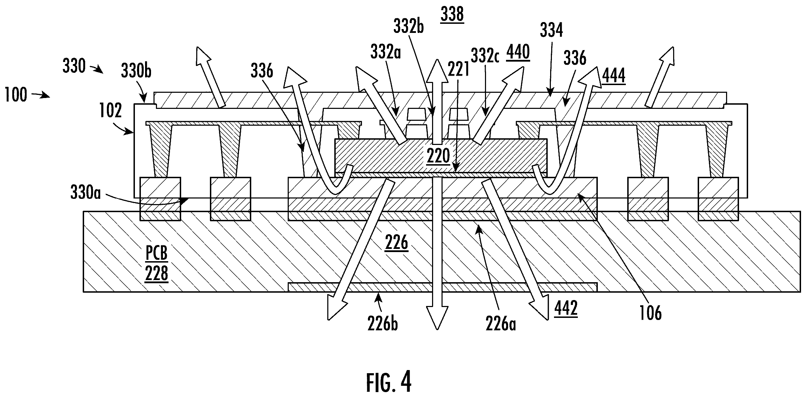

Referring now to FIG. 4, example thermal dissipation paths 440, 442, 444 in the example lead-frame package 330 are depicted.

As depicted in FIG. 4, a first thermal dissipation path 442 transmits heat into and/or through the PCB 228. For example, heat generated by the semiconductor IC 220 is transmitted through the die attach substance 221 and into the die pad 106. The heat is then dissipated into the external environment 338 by the thermal dissipation region 226 of the PCB 228. The thermal dissipation region 226 may include thermal conductive surfaces 226a, 226b positioned to transmit the heat from the first thermal dissipation path 442 and dissipate the heat into the external environment 338. In some embodiments, the thermal dissipation region 226 may include a cavity exposing at least a portion of the thermal die pad 106 to the external environment 338.

As further depicted in FIG. 4, a second thermal dissipation path 440 dissipates heat at the top surface 330b of the lead-frame package 330. For example, heat generated by the semiconductor IC 220 is transmitted through one or more of the plurality of thermally conductive paths 332a - 332c to the thermal dissipation surface 334 disposed on the top surface 330b of the lead-frame package 330. The thermal dissipation surface 334 enables dissipation of heat into the external environment 338.

As further depicted in FIG. 4, a third thermal dissipation path 444 dissipates heat also at the top surface 330b of the lead-frame package 330. For example, heat generated by the semiconductor IC 220 is transmitted through the die attach substance 221 and into the die pad 106. In the third thermal dissipation path 444, the heat is further transmitted through one or more of the plurality of thermally conductive die pad paths 336 to the thermal dissipation surface 334 disposed on the top surface 330b of the lead-frame package 330. The third thermal dissipation path 444 utilizing the thermally conductive die pad paths 336 may further improve the rate and efficiency with which heat generated by the semiconductor IC 220 is dissipated.

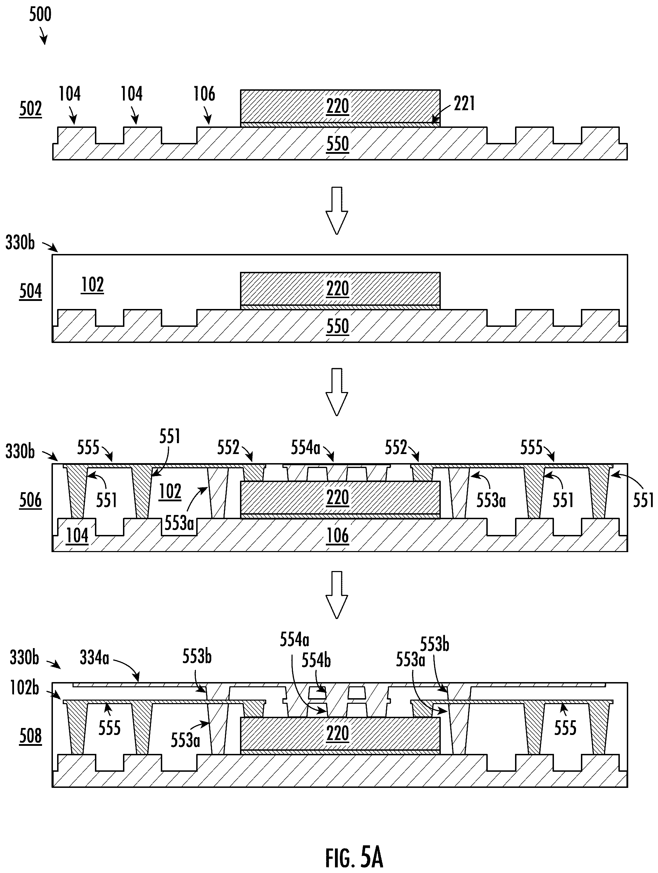

Referring now to FIG. 5A - FIG. 5B, a process 500 for manufacturing a lead-frame package (e.g., lead-frame package 330) with improved heat dissipation is provided. At block 502 of FIG. 5A, a die base 550 (e.g., lead-frame) is formed. A die base 550 comprises any material with a thermal conductivity greater than 100 Watts per meter per degree Kelvin, for example, Zinc, Aluminum, Copper, Silver, and so on. The die base 550 may be formed by any method configured to form the structures for the leads 104 and the die pad 106. For example, etching and/or stamping may be used to define the structures of the die base 550. With etching, a thin die base 550 material may be etched using dry or wet etching techniques. Etching removes unwanted material from the die base 550 to form the structures (e.g., leads 104, die pad 106). Stamping shapes the die base 550 to form the desired structures (e.g., leads 104, die pad 106). A semiconductor IC 220 is attached to the die pad 106 portion of the die base 550 using a die attach substance 221.

At block 504, a molding material 102 is disposed on the surface of the die base 550 and surrounding the semiconductor IC 220. The molding material 102 provides protection to the semiconductor IC 220 and other electrical connections from the external environment. The molding material 102 defines a top surface 330b of the lead-frame package. The molding material 102 may be disposed using an injection molding method. For example, by injecting a molten molding material 102 on the surface of the die base 550, forming a package, and allowing the molten molding material 102 to cool. The molding material 102 may comprise a resin, a polymer plastic, or other similar material.

At block 506, lead vias 551, IC connector vias 552, thermal conduction die pad vias 553a and thermal conduction IC vias 554a are formed from the top surface 330b of the molding material 102. Vias may be formed by drilling or etching through the molding material 102. The vias may be filled with a conductive material to enable transmission of electrical signals. In some embodiments, a thin seed layer of conductive material may be formed on the surface of the molding material by a laser, for example utilizing a laser direct structuring process. A laser direct structuring process enables a conductive trace to be formed directly on an injection-molded plastic with application of laser energy. Additional conductive material may be added to the seed layer, for example, through electroplating. In some embodiments, the lead vias 551, IC connector vias 552, thermal conduction die pad vias 553a and thermal conduction IC vias 554a may comprise copper material.

Lead vias 551 form an electrically conductive path to the leads 104 and IC connector vias 552 form an electrically conductive path to the semiconductor IC 220. In addition, an electrically conductive trace 555 is formed between each lead via 551 and an IC connector via 552 at an electrical connection point on the semiconductor IC 220. The electrically conductive trace 555 forms a conductive path (e.g., conductive bond wire 222) from each lead 104 to the semiconductor IC 220. Electrically conductive traces 555 may be formed by applying a seed layer and utilizing an electroplating process to further collect conductive materials within the conductive traces 555.

Thermal conduction die pad vias 553a form a thermally conductive path from the top surface 330b after the first molding process to the die pad 106. Similarly, thermal conduction IC vias 554a form a thermally conductive path from the top surface 330b after the first molding process to the semiconductor IC 220.

In some embodiments, additional conductive traces may be formed between the conduction die pad vias 553a and the thermal conduction IC vias 554a forming an electrical connection between the die pad 106 and the semiconductor IC 220. Electrically connecting the conduction die pad vias 553a and the thermal conduction IC vias 554a by conductive traces may enable the generation of conductive material in the conduction die pad vias 553a and the thermal conduction IC vias 554a by an electroplating process.

At block 508, a second portion of molding material 102b is formed on top of the conductive traces 555. The second portion of molding material 102b protects the conductive traces 555 forming the conductive bond wires from the external environment. The second portion of molding material 102b defines a new top surface 330b. In addition to protecting the conductive traces 555, the second portion of molding material 102b covers the previously formed thermal conduction die pad vias 553a and thermal conduction IC vias 554a. Thus, a second portion of the thermal conduction die pad vias 553b and thermal conduction IC vias 554b are formed from the top surface 330b of the molding material to interconnect with the first portion of the thermal conduction die pad vias 553a and thermal conduction IC vias 554a. The combination of the first portion of the thermal conduction die pad vias 553a and the second portion of the thermal conduction die pad vias 553b form a thermally conductive path from the top surface 330b of the molding material 102/102b to the die pad 106. The combination of the first portion of the thermal conduction IC vias 554a and the second portion of the thermal conduction IC vias 554b form a thermally conductive path from the top surface 330b of the molding material 102/102b to the semiconductor IC 220.

In addition, at block 508, a first portion of the thermal dissipation surface 334a is formed on the top surface 330b of the molding material 102/102b. Similar to the vias and traces, the first portion of the thermal dissipation surface 334a may be formed by applying a seed layer of a thermally conductive material and then growing the seed layer using electroplating techniques. The thermal dissipation surface 334a may be formed to cover a substantial portion of the top surface 330b. The thermal dissipation surface 334a provides a thermal conductive path (e.g., thermal dissipation path 440 and thermal dissipation path 444 as described in relation to FIG. 4) from the heat generating semiconductor IC 220 to the external environment out of the top surface 330b of the lead-frame package.

In some embodiments, a shielding tape may be applied to the bottom surface 330a of the die base 550 to prevent conductive material (e.g., copper) from forming on the bottom surface 330a of the die base 550.

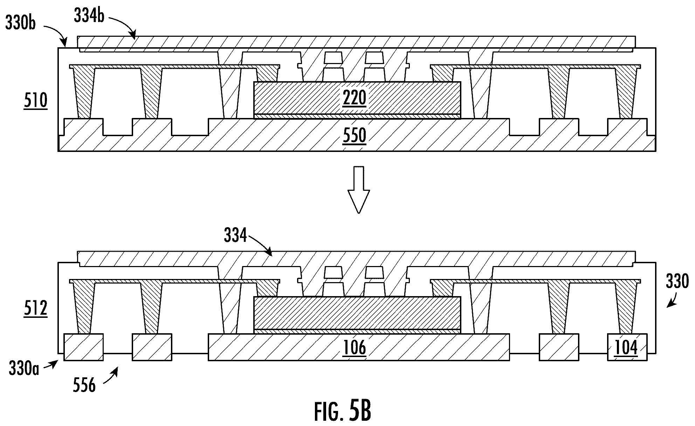

Referring now to FIG. 5B, the process 500 continues at block 510. At block 510, a second portion of the thermal dissipation surface 334b on the top surface 330b of the lead-frame package is formed. The second portion of the thermal dissipation surface 334b increases the surface area and cross-sectional area of the thermal dissipation surface 334 improving the efficiency with which heat may be dissipated from the semiconductor IC 220 and into an external environment. The second portion of the thermal dissipation surface 334b may be formed by an electroplating process.

At block 512, the die base 550 is etched to remove excess die base 550 material and insulate the die pad 106 and each of the leads 104. As depicted in block 512, a portion of the molding material 556 acts as an insulator between the conductive components (e.g., die pad 106, leads 104) on the bottom surface 330a of the lead-frame package 330. The die base 550 may be etched using any etching process, including wet etching and dry etching techniques.

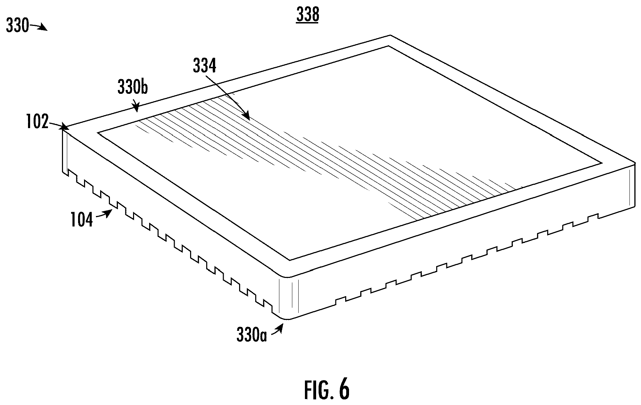

Referring now to FIG. 6, an example lead-frame package 330 comprising a thermal dissipation surface 334 is depicted. As depicted in FIG. 6, the thermal dissipation surface 334 covers a portion of the top surface 330b of the lead-frame package 330. In some embodiments, the thermal dissipation surface 334 may cover more than 30% of the surface area of the top surface 330b of the lead-frame package 330; more preferably, more than 50% of the surface area of the top surface 330b of the lead-frame package 330; most preferably, more than 75% of the surface area of the top surface 330b of the lead-frame package 330. Heat dissipation is directly proportional to the surface area of the thermal dissipation surface 334. Thus, a larger thermal dissipation surface 334 increases the heat transfer. In some embodiments, the thermal dissipation surface 334 may cover the entire top surface (e.g., ~100%) of the lead-frame package. In some embodiments, the thermal dissipation surface 334 The thermal dissipation surface 334 provides a heat dissipation path from the internal semiconductor IC to the external environment out the top surface 330b formed by the molding material 102. The top surface 330b being opposite the bottom surface 330a at which the leads 104 of the lead-frame package 330 are exposed.

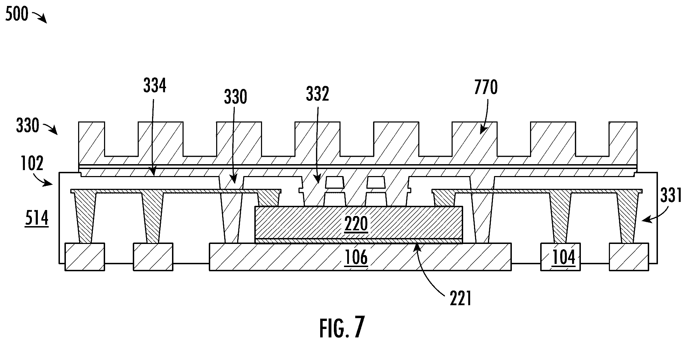

Referring now to FIG. 7, an additional block 514 in the process 500 is depicted. As depicted in FIG. 7, a finned protrusion 770 is positioned on the thermal dissipation surface 334 of the lead-frame package 330. In some embodiments, a finned protrusion 770 may be added to increase the surface area of the thermal dissipation surface 334a/334b and increase the efficiency with which heat is dissipated into the external environment. The rate of heat transfer from the thermal dissipation surface 334 to the external environment is directly proportional to the surface area exposed to the external environment. Thus, by adding finned protrusions 770 and increasing the surface area of the exposed surface, heat from the semiconductor IC may be dissipated more efficiently. Finned protrusions 770 may be formed by etching, molding, or otherwise forming the thermally conductive material. In addition, the finned protrusions 770 may be formed separately and attached to the thermal dissipation surface 334.

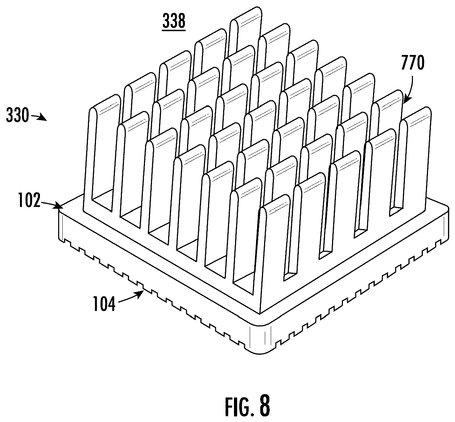

Referring now to FIG. 8, an example lead-frame package 330 including a thermal dissipation surface 334 having finned protrusions 770 is depicted. As depicted in FIG. 8, the finned protrusions 770 increase the surface area of thermally conductive material exposed to the external environment 338. Utilizing finned protrusions 770 to increase the surface area of the thermal dissipation surface 334a/334b increases the efficiency with which heat from the semiconductor IC is dissipated into the external environment 338.

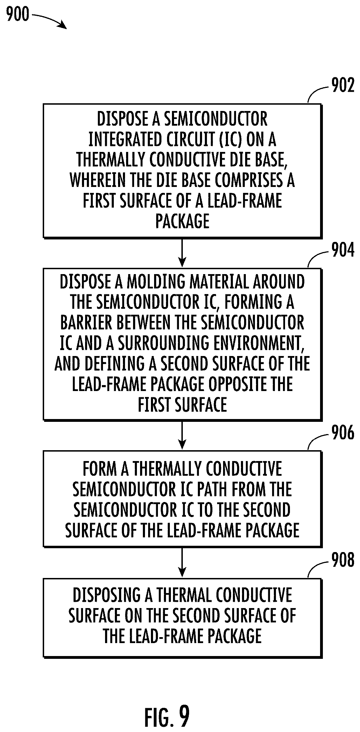

Referring now to FIG. 9, a method 900 for manufacturing a lead-frame package (e.g., lead-frame package 330) with improved heat dissipation characteristics is provided. At block 902, a semiconductor IC (e.g., semiconductor IC 220) is disposed on a thermally conductive die base (e.g., die base 550), wherein the die base comprises a first surface of the lead-frame package. As described herein, a semiconductor IC may be configured with circuitry including one or more processors to perform operations as part of an electrical system. During operation the semiconductor IC may generate heat. The thermally conductive die base, including a die pad (e.g., die pad 106) may provide a heat dissipation path through the bottom surface of the lead-frame package.

At block 904, a molding material (e.g., molding material 102) is disposed around the semiconductor IC, forming a barrier between the semiconductor IC and a surrounding environment (e.g., external environment 338), and defining a second surface (e.g., top surface 330b) of the lead-frame package opposite the first surface. A molding material may comprise a resin, plastic polymer, or similar material configured to protect the semiconductor IC, conductive bond wires, and other electrical components from the external environment. The molding material may be formed to define a second, top surface of the lead-frame package opposite the die pad and leads.

At block 906, a thermally conductive semiconductor IC path (e.g., thermally conductive paths 332a - 332c) is formed from the semiconductor IC to the second surface of the lead-frame package to the semiconductor IC. One or more vias may be formed from the top surface of the molding material comprising the lead-frame package to the semiconductor IC. The vias may be filled with a thermally conductive material providing a thermally conductive path from the semiconductor IC to the top surface of the molding material.

At block 908, a thermal dissipation surface (e.g., thermal dissipation surface 334, finned protrusions 770) is disposed on the second surface of the lead-frame package, wherein the thermal dissipation surface provides a thermal dissipation path (e.g., thermal dissipation path 440, 444) from the semiconductor IC to the second surface of the lead-frame package. As described herein, a thermal dissipation surface is formed on the top surface of the molding material. The thermal dissipation surface may be formed by any thermally conductive material, for example copper. The thermal dissipation surface may be formed using an electroplating technique. The thermal dissipation surface interfaces with the external environment enabling the dissipation of heat generated by the semiconductor IC. In some embodiments, the thermal dissipation surface may comprise or be thermally coupled to a plurality of finned protrusions to increase the efficiency of heat dissipation into the external environment.

Utilizing the techniques described herein, a lead-frame package may enable a plurality of heat dissipation paths, including at least a heat dissipation path out the bottom surface of the lead-frame package toward a PCB or other attaching surface. In addition, the lead-frame package described herein includes at least a heat dissipation path out the top surface of the lead-frame package, away from the PCB or other attaching surface. The additional heat dissipation path may increase the rate and efficiency at which heat is dissipated from the semiconductor IC. The increased heat dissipation may improve the performance, reliability, and durability of the lead-frame package and semiconductor IC, particularly in harsh environments.

While this detailed description has set forth some embodiments of the present invention, the appended claims cover other embodiments of the present invention which differ from the described embodiments according to various modifications and improvements. For example, one skilled in the art may recognize that such principles may be applied to any lead-frame package configured to dissipate heat from an internal, heat generating electrical component.

Within the appended claims, unless the specific term "means for" or "step for" is used within a given claim, it is not intended that the claim be interpreted under 35 U.S.C. 112, paragraph 6.

Use of broader terms such as "comprises," "includes," and "having" should be understood to provide support for narrower terms such as "consisting of," "consisting essentially of," and "comprised substantially of" Use of the terms "optionally," "may," "might," "possibly," and the like with respect to any element of an embodiment means that the element is not required, or alternatively, the element is required, both alternatives being within the scope of the embodiment(s). Also, references to examples are merely provided for illustrative purposes, and are not intended to be exclusive.

## Claims

1. A lead-frame package comprising:
a first surface and a second surface opposite the first surface;
a semiconductor integrated circuit (IC) thermally coupled to a die pad, the die pad comprising a portion of the first surface of the lead-frame package; and
a thermal dissipation surface at the second surface of the lead-frame package thermally coupled to the semiconductor IC,
wherein the thermal dissipation surface provides a thermal dissipation path from the semiconductor IC to the second surface of the lead-frame package.

2. The lead-frame package of claim 1, further comprising:
a molding material formed around the semiconductor IC protecting the semiconductor IC from a surrounding environment and defining at least a portion of the first surface and the second surface,
wherein the thermal dissipation surface is exposed to the surrounding environment.

3. The lead-frame package of claim 2, further comprising:
a lead terminating at the first surface and electrically coupled to the semiconductor IC,
wherein the molding material insulates the lead from the die pad.

4. The lead-frame package of claim 3, wherein the lead is electrically coupled to the semiconductor IC by a conductive bond wire.

5. The lead-frame package of claim 4, wherein the lead is configured to attach to a conductive pad of a printed circuit board (PCB).

6. The lead-frame package of claim 4, wherein the first surface comprises a plurality of rows of leads.

7. The lead-frame package of claim 2, wherein the molding material comprises at least one of a resin and a polymer plastic.

8. The lead-frame package of claim 1, further comprising a thermally conductive die pad path creating a thermally conductive path directly from the die pad to the thermal dissipation surface.

9. The lead-frame package of claim 1, further comprising:
a plurality of finned protrusions extending from the thermal dissipation surface.

10. The lead-frame package of claim 1, wherein the thermal dissipation surface comprises copper.

11. The lead-frame package of claim 1, wherein the lead-frame package comprises a quad-flat no-leads (QFN) package.

12. A method of manufacturing a lead-frame package, comprising:
disposing a semiconductor IC on a thermally conductive die base, wherein the die base comprises a first surface of the lead-frame package;
disposing a molding material around the semiconductor IC, forming a barrier between the semiconductor IC and a surrounding environment, and defining a second surface of the lead-frame package opposite the first surface;
forming a thermally conductive semiconductor IC path from the semiconductor IC to the second surface of the lead-frame package; and
disposing a thermal dissipation surface on the second surface of the lead-frame package,
wherein the thermal dissipation surface provides a thermal dissipation path from the semiconductor IC to the second surface of the lead-frame package.

13. The method of claim 12, further comprising:
etching the die base to form a die pad and a lead, exposing a portion of the molding material,
wherein the molding material insulates the die pad from the lead.

14. The method of claim 13, further comprising:
forming an electrically conductive path from the lead to the semiconductor IC.

15. The method of claim 13, further comprising:
forming a thermally conductive path from the die pad to the semiconductor IC.

16. The method of claim 13, wherein the lead is configured to attach to a conductive pad of a printed circuit board (PCB).

17. The method of claim 13, further comprising forming a plurality of rows of leads from the die base.

18. The method of claim 12, further comprising:
forming a plurality of finned protrusions extending from the thermal dissipation surface away from the second surface.

19. The method of claim 12, wherein the molding material comprises at least one of a resin and a polymer plastic.

20. An electrical system, comprising:
a printed circuit board (PCB) comprising a conductive pad and a thermal dissipation region;
a lead-frame package comprising:
a first surface and a second surface opposite the first surface;
a semiconductor IC thermally coupled to a die pad, the die pad comprising a first portion of the first surface of the lead-frame package;
a lead electrically coupled to the semiconductor IC, the lead comprising a second portion of the first surface thermally isolated from the first portion;
a thermal dissipation surface at the second surface of the lead-frame package thermally coupled to the semiconductor IC,
wherein the thermal dissipation surface provides a first thermal dissipation path from the semiconductor IC to the second surface of the lead-frame package;
wherein the lead is electrically coupled to the conductive pad of the PCB, and
wherein the die pad provides a second thermal dissipation path from the semiconductor IC to the thermal dissipation region of the PCB.
